Europäisches Patentamt

European Patent Office

Office européen des brevets

(11) Publication number: **0 275 610 B1**

(12) **EUROPEAN PATENT SPECIFICATION**

(45) Date of publication of patent specification: **25.03.92**

(21) Application number: **87202646.3**

(22) Date of filing: **30.12.87**

(51) Int. Cl.⁵: **H04B 10/00**, H04J 15/00, H01S 3/23, H01S 3/13

(54) **Optical transmitter.**

(30) Priority: **19.01.87 NL 8700108**

(43) Date of publication of application:
**27.07.88 Bulletin 88/30**

(45) Publication of the grant of the patent:
**25.03.92 Bulletin 92/13**

(84) Designated Contracting States:
**DE FR GB IT SE**

(56) References cited:
**DE-A- 3 509 354**
**FR-A- 2 519 216**
**GB-A- 2 170 370**
**US-A- 4 163 954**
**US-A- 4 485 475**

(73) Proprietor: **N.V. Philips' Gloeilampenfabrieken**
**Groenewoudseweg 1**
**NL-5621 BA Eindhoven(NL)**

(72) Inventor: **Khoe, Giok Djan**
**c/o INT. OCTROOIBUREAU B.V. Prof. Holstlaan 6**
**NL-5656 AA Eindhoven(NL)**
Inventor: **Wong, Ching Kwok**
**c/o INT. OCTROOIBUREAU B.V. Prof. Holstlaan 6**
**NL-5656 AA Eindhoven(NL)**

(74) Representative: **Peters, Rudolf Johannes et al**
**INTERNATIONAAL OCTROOIBUREAU B.V.**
**Prof. Holstlaan 6**
**NL-5656 AA Eindhoven(NL)**

## Description

The invention relates to an optical transmission device comprising a plurality of semiconductor lasers for transmitting an equal plurality of respective radiation beams modulated with respective information streams and having respective wavelengths which are different for each radiation beam, a measuring system for measuring the wavelength of the radiation beam from each semiconductor laser, a selection device for successively and temporarily selecting the wavelength to be measured, and a control device for influencing the wavelengths of the semiconductor lasers as a function of a signal generated by the measuring system.

Optical transmission lines in the form of glass fibers are increasingly being used for transmitting information. Due to the large transmission capacity of glass fibers, large information streams can be presented to a subscriber. Such an information stream may be, for example a television broadcast, another video or audio programme, or data from a central file. By using a wavelength-sensitive receiver a multitude of programmes, each with their own carrier frequency, can be presented from which the subscriber can simply make a choice by means of tuning. Radiation in the wavelength range of 1.3 to 1.55 $\mu$m is attenuated to a slight extent only in the glass fiber so that this is one of the ranges which is suitable for the transmission of information through a glass fiber. Several hundred information streams, each with their own carrier frequency, can be transmitted within this range.

In a central transmission device each information stream is transmitted as a series of optical signals by a semiconductor laser. With the aid of a system of beam-splitting and beam-combining elements the signals are passed through a plurality of glass fibre transmission lines each leading to a subscriber.

The wavelength of radiation emitted by a semiconductor laser is dependent on a number of parameters, inter alia external parameters, for example the ambient temperature. The wavelength thus tends to drift when one or more of these parameters varies. In order to prevent confusion to the subscriber about the selected programme, the wavelength of the carrier signal is to be maintained constant in an optical transmission device.

An optical transmission device of this type is known from the UK patent application GB 2 170 370A. The known device comprises multiple lasers, modulated by data. Each laser generates a radiation beam with a different, distinct wavelength. The wavelength of each laser is controlled by a thermoelectric cooler. A wavelength multiplexer combines the radiation beams in one output fibre. In order to obtain maximum transmission through the multiplexer, the wavelength of each laser must be controlled to make it coincide with the centre of the multiplexer response for that channel. To this end, part of the output of the multiplexer is transferred to a photodiode. To assure the measurement of the output of only one, selected laser, the device contains an oscillator, which provides a bias modulation for the lasers. An electrical switch selects the laser to which the bias modulation is sent. A phase sensitive detector extracts the component signal from the output of the photodiode which has the same frequency as the bias modulation. This component signal is a measure for the transmission of the beam of the selected laser through the multiplexer. A control circuit uses the component signal to control the current through the cooler of the selected laser, in order to move the wavelength of the laser to the wavelength that gives maximum transmission.

In the known device a multiplexer is used as wavelength discriminator. This use limits the choice of multiplexers, as it puts strict requirements on it: each input must have a different maximum transmission wavelength; a channel may have only one maximum transmission wavelength; no zero transmission is allowed in the range over which the laser wavelength can drift. In case one uses a grating as multiplexer, the wavelengths for maximum transmission strongly depend on the orientation of the input and output fibres with respect to the grating. Hence, the carrier wavelengths in the output fibre will be determined by the manufacturing tolerances of the multiplexer, and will drift with the thermal expansion of the multiplexer, in spite of the presence of the described wavelength stabilization.

Moreover, in the known device a bias modulation should be imparted to the lasers. This modulation is also present on the output fibre, and can impair the quality of the signal to be decoded by the recipient.

It is an object of the invention to provide an optical transmission device in which these drawbacks do not occur.

To this end the optical transmission device according to the invention is characterized in that the measuring system comprises a wavelength meter and that the selection device is an optical selector. The wavelength meter is substantially insensitive to external influences which may occur in the transmission device. The signals in the output fibres are not affected by the stabilization process. Another advantage is the speed with which the device can control the wavelength of a laser. In the known device, the maximum transmission of the multiplexer must be found by trial and error. The device according to the invention provides a signal that represents both the direction and the amount of correction necessary. Hence, the control process is faster.

A first embodiment of the optical transmission device according to the invention is characterized in that the selection device is a switching device for establishing and interrupting a radiation path from each semiconductor laser to the wavelength meter. In this embodiment the wavelength of each semiconductor laser is measured directly.

This embodiment of the optical transmission device according to the invention may be further characterized in that the switching device comprises electro-optical means for establishing and interrupting the respective radiation paths. Consequently, moving parts in the switching device are not necessary.

A second embodiment of the optical transmission device according to the invention is characterized in that the selection device comprises a control laser, a beam-combining element and an opto-electric converter, which control laser is suitable for emitting radiation whose wavelength is variable throughout the wavelength range of the semiconductor lasers, which beam-combining element is arranged in the radiation path of the radiation emitted by the semiconductor lasers and the control laser for obtaining a combined radiation beam comprising at least a portion of the radiation from each laser, which output is connected to the opto-electric converter which has a wavelength range which is smaller than the difference of the nominal wavelengths of the semiconductor lasers, and in that the wavelength meter is arranged in a radiation path of radiation from the control laser. As a result of this limited wavelength range, the opto-electric converter only supplies an AC signal when the wavelength of the radiation emitted by the semiconductor laser is substantially equal to that of one of the semiconductor lasers. By measuring this wavelength at that instant, also the wavelength of the radiation emitted by the relevant semiconductor laser is determined by means of a direct measurement.

It is remarked that a device is known from the contribution by E.J. Bachus et al. to the conference IOOC-ECOC '85 held in Venice (Italy) in October 1985, entitled "Coherent optical subscriber line", pages 61-64, wherein the output of three semiconductor lasers is combined with the output of a control laser the known device, however, does not comprise a wavelength meter. The wavelength of the radiation of the control laser is varied by means of a sawtooth generator over the wavelength range of the three lasers. When the wavelength of the radiation of the control laser is equal to the wavelength of the radiation of one of the three other lasers, a detection circuit issues a pulse. By comparing the voltage at the output of the sawtooth generator at that instant with the nominal wavelength of the associated semiconductor laser, a possible deviation between the actual and the required value can be determined. By modifying the temperature the associated laser is then tuned. In order to prevent drift of the wavelength of the control laser and as a result a drift of the three lasers, one of the semiconductor lasers is absolutely stabilized by means of a feedback loop incorporating a fibre ringresonator. An apparent deviation of the wavelength of the radiation from this laser is corrected by modifying the temperature of the control laser.

In this known device the fibre ring-resonator must be shielded extremely well from external influences in order to prevent the resonance frequency from changing. Furthermore, a fibre ring resonator is bulky and is therefore not very suitable to be built into a compact transmission device.

Moreover in the known device the wavelength of the semiconductor lasers is determined by comparing two quantities, namely the output voltage of the sawtooth generator and the wavelength of the radiation generated in the control laser, which quantities are indirectly coupled via a number of parameters of the control laser. If in the course of time one of these parameters changes, for example after replacement of this laser, the transmitting frequencies of the semiconductor lasers which are not absolutely stabilized change. The direct wavelength measurement according to the invention solves this problem.

The second embodiment of the optical transmission device according to the invention may be further characterized in that the wavelength of the radiation from the control laser is variable by changing both the temperature of and the current through the control laser. Consequently, a wavelength range can be covered which is larger than the wavelength range which can be covered by means of current control only. The number of semiconductor lasers in the optical transmission device according to the invention may thus be larger than in the device which is known from the afore-mentioned contribution by E.J. Bachus et al.

The optical transmission device according to the invention is further characterized in that the wavelengths of the radiation emitted by the semiconductor lasers are influenced by changes in the temperature of and the current through the semiconductor laser. The current flowing through the semiconductor laser influences the optical properties of the laser so that a wavelength control is possible which reacts more rapidly than a temperature change alone.

The invention will now be described in greater detail with reference to the accompanying drawing in which

Figure 1 shows diagrammatically the stabilisation system in an optical transmission device according to the invention,

Figure 2 shows diagrammatically a first embodiment of the optical transmission device and

Figure 3 shows diagrammatically a second embodiment of the optical transmission device.

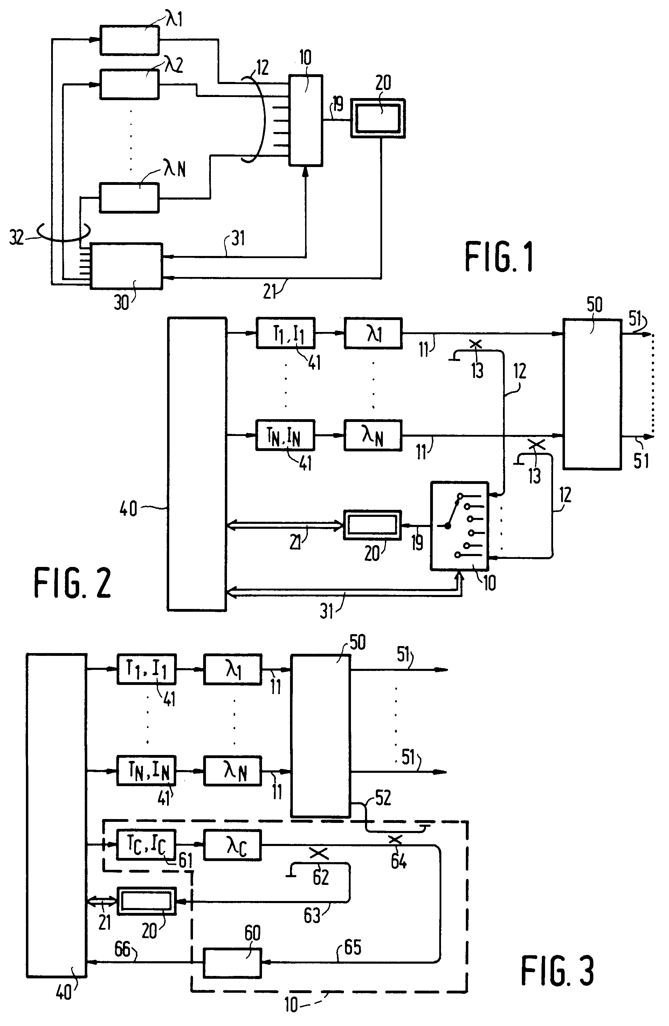

In Figure 1 the series $\lambda_1$, $\lambda_2$, ..., $\lambda_N$ denotes a plurality of semiconductor lasers. Radiation from each laser is applied via the bundle of fibres 12 to the selection device 10. The output 19 of the selection device 10 emits radiation whose wavelength corresponds to the wavelength of the radiation entering one of the inputs. This wavelength is measured in the wavelength-meter 20 whereafter the value thereof is passed on via the connection 21 to the control device 30. In the case of a difference between the real and nominal values of the wavelength, the temperature of and/or the intensity of the current through the relevant laser is adapted via one of the connections 32 from the control device 30, so that the transmitted wavelength is corrected.

Figure 2 shows diagrammatically a first embodiment of an optical transmission device according to the invention. The outputs of the semiconductor lasers $\lambda_1$, ..., $\lambda_N$ are connected to the star coupler 50 via the connection paths 11, for example optical fibres. This coupler combines the radiation which enters each input and splits the combined radiation into a number of radiation beams each of which is passed to a subscriber via one of the outputs 51. Each radiation beam comprises radiation from all semiconductor lasers $\lambda_1$ to $\lambda_N$.

A coupler 13 which couples out a portion of the radiation propagating through the connection 11 and leads it via the connection 12 to the selection device 10 is arranged between each semiconductor laser $\lambda_1$ to $\lambda_N$ and the star coupler. The selection device selects one of the presented signals and passes it on to the wavelength meter 20 via the connection 19. The numerical value measured by the wavelength meter is passed on via the connection 21 to the control device incorporated in a computer 40. The selection device 10 is connected to the computer 40 via the connection 31 so that information relating to the selected semiconductor laser is present in the control device. With the aid of the computer the real value of the wavelength is compared with the nominal value for the selected semiconductor laser and in the case of a deviation the temperature of and/or the intensity of the current through the laser is adapted by means of the control circuits 41 provided for this purpose.

The information streams which must be passed on by the lasers may be presented to the lasers via the computer 40 and the control circuits 41, but alternatively a separate information-processing system may be incorporated in the device for this purpose.

The most important requirement imposed on the wavelength meter is that it must have a satisfactory stability independent of ambient influences such as temperature and atmospheric pressure. Since drift of the real wavelengths of the semiconductor lasers can be tolerated within limits determined by the nominal distance between neighbouring channels, a high measuring rate is much less important. A wavelength meter complying with the requirements is marketed by Advantest under the type number TQ8325.

Figure 3 shows diagrammatically a second embodiment of the opical transmission device according to the invention. Likewise as in Figure 2, the references $\lambda_1$, ..., $\lambda_N$ denote the semiconductor lasers for transmitting the information streams. The radiation from these lasers is passed on to the star coupler 50 via the connections 11 and is combined and split up in this coupler and subsequently transmitted to the subscribers via the outputs 51. The selection device is composed of a number of elements shown within the broken line 10. The radiation from one of the outputs of the star coupler 50, denoted by the reference numeral 52, is combined by means of the coupler 64 with radiation generated by the control laser $\lambda_c$. The combined radiation is passed on through the connection 65 to the opto-electric converter 60. This converter is only sensitive to low frequencies and only supplies an AC signal when the frequency difference between the radiation from the control laser and one of the other semiconductor lasers is sufficiently small. A portion of the control laser radiation is applied to the wavelength meter 20 by means of the coupler 62 and the connection 63. The numerical value of the wavelength of the semiconductor laser radiation determined in this meter, together with the AC signal from the opto-electric converter 60, constitutes sufficient information to determine the real wavelength of the radiation from the semiconductor laser to be measured. By causing the wavelength of the control laser $\lambda_c$ to vary by means of the control circuit 61, the real wavelength of each semiconductor laser $\lambda_1$, ..., $\lambda_N$ can be successively measured, whereafter, if necessary, the laser can be tuned by means of the associated control circuits 41.

**Claims**

1. An optical transmission device comprising a plurality of semiconductor lasers ($\lambda_1$ ... $\lambda_N$) for transmitting an equal plurality of respective radiation beams (11) modulated with respective information streams and having respective wavelengths which are different for each radiation beam, a measuring system (20) for measuring the wavelength of the radiation beam from each semiconductor laser, a selection device (10) for successively and temporarily selecting the wavelength to be measured, and a control device (30) for influencing the wavelengths of the semiconductor lasers as a function of a signal generated by the measuring system, characterized in that the measuring system comprises a wavelength meter (20) for measuring the wavelength of radiation emitted by one semiconductor laser and in that the selection device is an optical selector (10).

2. An optical transmission device as claimed in Claim 1, characterized in that the selection device (10) is a switching device for establishing and interrupting a radiation path (11, 13, 12, 19) from each semiconductor laser ($\lambda_1...\lambda_N$) to the wavelength meter (20).

3. An optical transmission device as claimed in Claim 2, characterized in that the switching device (10) comprises electro-optical means for establishing and interrupting the respective radiation paths.

4. An optical transmission device as claimed in Claim 1, characterized in that the selection device (10) comprises a control laser ($\lambda_c$), a beam-combining element (64) and an opto-electric converter (60), which control laser is suitable for emitting radiation whose wavelength is variable throughout the wavelength range of the semiconductor lasers ($\lambda_1...\lambda_N$), which beam-combining element is arranged in the radiation path of the radiation emitted by the semiconductor lasers and the control laser for obtaining a combined radiation beam (65) comprising at least a portion of the radiation from each laser, which output is connected to the opto-electric converter wich has a wavelength range which is smaller than the difference of the nominal wavelengths of the semiconductor lasers, and in that the wavelength meter (20) is arranged in a radiation path (63) of radiation from the control laser.

5. An optical transmission device as claimed in Claim 4, characterized in that the wavelength of the radiation from the control laser ($\lambda_c$) is variable by changing both the temperature of and the current through the control laser.

6. An optical transmission device as claimed in Claim 1, 2, 3, 4 or 5, characterized in that the wavelengths of the radiation emitted by the semiconductor lasers ($\lambda_1...\lambda_N$) are influenced by changes in the temperature of and the current through the semiconductor laser.

## Revendications

1. Dispositif d'émission optique comportant plusieurs lasers semiconducteurs ($\lambda_1 ... \lambda_N$) pour l'émission d'un nombre égal de faisceaux de rayonnement respectifs (11) modulés avec des courants d'information respectifs et présentant de longueurs d'onde respectives qui sont différentes pour chaque faisceau de rayonnement, un système de mesure (20) pour la mesure de la longueur d'onde du faisceau de rayonnement de chaque laser, un dispositif de sélection (10) pour sélectionner successivement et temporairement la longueur d'onde à mesurer, et un dispositif de commande (30) pour influer sur la longueur d'onde des lasers semiconducteurs en fonction d'un signal engendré par le système de mesure, caractérisé en ce que le système de mesure comporte un dispositif de mesure de longueurs d'onde (20) pour la mesure de la longueur d'onde du rayonnement émis par un laser semiconducteur et en ce que le dispositif de sélection est un sélecteur optique (10).

2. Dispositif d'émission optique selon la revendication 1, caractérisé en ce que le dispositif de sélection (10) est un dispositif de commutation pour établir et interrompre un trajet de rayonnement (11, 13, 12, 19) à partir de chaque laser semiconducteur ($\lambda_1 ... \lambda_N$) vers le dispositif de mesure de longueurs d'onde (20).

3. Dispositif d'émission optique selon la revendication 2, caractérisé en ce que le dispositif de commutation (10) comporte des moyens électro-optiques pour établir et interrompre les trajets de rayonnement respectifs.

4. Dispositif d'émission optique selon la revendication 1, caractérisé en ce que le dispositif de sélection (10) comporte un laser de commande ($\lambda_c$), un élément de combinaison de faisceaux (64) et un convertisseur optoélectrique (60), lequel laser de commande est approprié à l'émission de rayonnement dont la longueur d'onde peut varier sur toute la gamme de longueurs d'onde des lasers semiconducteurs ($\lambda_1 ... \lambda_N$), lequel élément de combinaison de faisceaux est disposé dans le trajet de rayonnement du rayonnement émis par les lasers semiconducteurs et le laser de commande pour l'obtention, à au moins une sortie du système, d'un faisceau de rayonnement combiné (65) contenant au moins une partie du rayonnement provenant de chaque laser, laquelle sortie est connectée au convertisseur opto-électrique qui présente une gamme de longueurs d'onde inférieure à la différence des longueurs d'onde nominales des lasers semiconducteurs, et en ce que le dispositif de mesure de longueurs d'onde (20) est disposé dans un trajet de rayonnement du rayonnement provenant du laser de commande.

5. Dispositif d'émission optique selon la revendication 4, caractérisé en ce que la longueur d'onde du rayonnement provenant du laser de commande est variable par variation de la température du laser ($\lambda_c$) de commande et du courant traversant ledit laser de commande.

6. Dispositif d'émission optique selon la revendication 1, 2, 3, 4 ou 5, caractérisé en ce que les longueurs d'onde du rayonnement émis par les lasers semiconducteurs ($\lambda_1 \ldots \lambda_N$) sont influencées par des variations de la température et du courant traversant le laser semiconducteur.

**Patentansprüche**

1. Optische Übertragungsanordnung mit einer Anzahl von Halbleiterlasern ($\lambda_1 \ldots \lambda_N$) zum Übertragen einer gleichen Anzahl in bezug auf jeweilige Informationsflüsse modulierter jeweiliger Strahlungsbündel (11) mit jeweiligen Wellenlängen, die für jedes Strahlungsbündel verschieden sind, mit einem Meßsystem (20) zum Messen der Wellenlänge des Strahlungsbündels aus jedem Halbleiterlaser, mit einer Wählanordnung (10) zum aufeinanderfolgenden und zeitlichen Wählen der zu messenden Wellenlänge, und mit einer Steueranordnung (30) zum Beeinflussen der Wellenlängen der Halbleiterlaser in Abhängigkeit von einem im Meßsystem erzeugten Signal, dadurch gekennzeichnet, daß das Meßsystem einen Wellenlängenmesser (20) zum Messen der Wellenlänge der von nur einem Halbleiterlaser ausgesandten Strahlung enthält, und daß die Wählanordnung ein optischer Wähler (10) ist.

2. Optische Übertragungsanordnung nach Anspruch 1, dadurch gekennzeichnet, daß die Wählanordnung (10) eine Schaltanordnung zum Erstellen und Unterbrechen eines Strahlungsweges (11, 13, 12, 19) von jedem Halbleiterlaser ($\lambda_1 \ldots \lambda_N$) zum Wellenlängenmesser (20) ist.

3. Optische Übertragungsanordnung nach Anspruch 2, dadurch gekennzeichnet, daß die Schaltanordnung (10) elektrooptische Mittel zum Erstellen und Unterbrechen der jeweiligen Strahlungswege enthält.

4. Optische Übertragungsanordnung nach Anspruch 1, dadurch gekennzeichnet, daß die Wählanordnung (10) einen Steuerlaser ($\lambda_c$), ein Bündelverknüpfungselement (64) und einen optoelektrischen Umsetzer (60) enthält, der Steuerlaser sich zum Aussenden von Strahlung eignet, deren Wellenlänge über den Wellenlängenbereich der Halbleiterlaser ($\lambda_1 \ldots \lambda_N$) änderbar ist, das Bündelverknüpfungselement im Strahlungsweg der von den Halbleiterlasern ausgesandten Strahlung angeordnet ist und der Steuerlaser zum Erhalten eines kombinierten Strahlungsbündels (65) wenigstens einen Teil der Strahlung aus jedem Laser umfaßt, und der Elementausgang mit dem optoelektrischen Umsetzer verbunden ist, dessen Wellenlängenbereich Kleiner ist als der Unterschied zwischen den Nennwellenlängen der Halbleiterlaser, und daß der Wellenlängenmesser (20) in einem Strahlungsweg (63) der Strahlung aus dem Steuerlaser angeordnet ist.

5. Optische Übertragungsanordnung nach Anspruch 4, dadurch gekennzeichnet, daß die Wellenlänge der Strahlung aus dem Steuerlaser ($\lambda_c$) durch Änderungen sowohl in der Temperatur des Steuerlasers als auch im Strom durch den Steuerlaser variabel ist.

6. Optische Übertragungsanordnung nach Anspruch 1, 2, 3, 4 oder 5, dadurch gekennzeichnet, daß die Wellenlängen der von den Halbleiterlasern ($\lambda_1 \ldots \lambda_N$) ausgesandten Strahlung durch Änderungen in der Temperatur des Halbleiterlasers und im Strom durch diesen Laser beeinflußt werden.

FIG.1

FIG. 2

FIG. 3